**Europäisches Patentamt**

**European Patent Office**

**Office européen des brevets**

(19)

(11) Publication number: **0 100 727**
**B1**

(12)

# EUROPEAN PATENT SPECIFICATION

(45) Date of publication of patent specification: **21.09.88**

(51) Int. Cl.⁴: **H 01 L 23/48**

(21) Application number: **83401542.2**

(22) Date of filing: **27.07.83**

(54) Semiconductor device comprising a ceramic base.

(30) Priority: **30.07.82 JP 133113/82**

(43) Date of publication of application:
**15.02.84 Bulletin 84/07**

(45) Publication of the grant of the patent:
**21.09.88 Bulletin 88/38**

(84) Designated Contracting States:
**DE FR GB**

(56) References cited:
**EP-A-0 027 017**
**DE-A-2 938 567**

**IBM TECHNICAL DISCLOSURE BULLETIN, vol.
20, no. 10, March 1978, page 3872, New York,
US; E. STEPHANS: "Pinless module connector"
IBM TECHNICAL DISCLOSURE BULLETIN, vol.
21, no. 9, February 1979, page 3591, New York,
US; C.S.K. NG: "Circuit module package"**

**PATENTS ABSTRACTS OF JAPAN, vol. 5, no.
159 (E-77)831r, 14th October 1981; & JP - A - 56
88343 (FUJITSU K.K.) 17-07-1981**

(73) Proprietor: **FUJITSU LIMITED
1015, Kamikodanaka Nakahara-ku
Kawasaki-shi Kanagawa 211 (JP)**

(72) Inventor: **Wakabayashi, Tetsuhi
780-1, Minowa-cho Kohoku-ku
Yokohama-shi Kanagawa 223 (JP)**

(74) Representative: **Descourtieux, Philippe et al
CABINET BEAU de LOMENIE 55 rue
d'Amsterdam
F-75008 Paris (FR)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

## Description

### Field of the invention

The present invention relates to a semiconductor device, more particularly to a leadless chip carrier (LCC) type semiconductor integrated circuit (IC) device.

### Description of the prior art

LCC type semiconductor IC devices have come into wide use due to their compactness compared with outer lead types. An LCC type semiconductor device comprises a ceramic base having a cavity in the central portion thereof, a semiconductor chip mounted on the ceramic base and in the cavity, a plurality of soldering pads on the top or bottom surface of the ceramic base for making electrical connection with an external board by soldering, and electrical connections between the semiconductor chip and the soldering pads.

A multi-layer ceramic chip carrier of the leadless type is disclosed in EP—A—0 027 017, the soldering pads being connected to the semiconductor chip by wirings on surfaces of the layers and through holes in the layers.

In IBM Technical Disclosure Bulletin Vol. 21 No. 9, February 1979, a circuit module package is disclosed using solder bonding between an IC chip and a pin carrier substrate. Solder balls provided on the tops of through holes formed in the IC chip are thermally reflowed to allow the solder to travel downwardly through the holes to form the required bonding. In this known device, connection of the module package with external circuits is made using the pins carried by the pin carrier substrate.

In prior art LCC type semiconductor devices using soldering pads for making electrical connection with an external board, the soldering pads are formed, e.g., by screen-printing tungsten paste on a green ceramic base and by firing it. The electrical connections between the semiconductor chip and the soldering pads are formed by metallization lines in and on the ceramic base and wires between the metallization lines and the semiconductor chip. Recent increases in the degree of integration of IC's, however, have made it necessary to provide a larger number of soldering pads in the semiconductor device, requiring more precise formation of smaller soldering pads. It is, however, difficult to precisely form extremely fine patterns of soldering pads, i.e., to precisely form very small soldering pads at very short pitches therebetween, by the screen-printing method. There is a limit to the fineness of patterns which can be formed by a printing screen. Further, metal paste printed on a ceramic base through a printing screen tends to flow and spread out from the preformed pattern, causing short-circuits by soldering when the semiconductor device is bonded onto an external circuit board.

Further, warping of a ceramic base becomes a problem when the number of soldering pads in the semi-conductor device increases so that the size and space of soldering pads decreases. Warping of a ceramic base may obstruct soldering between some small soldering pads on the warped surface of the ceramic base and external circuit board. To reduce this problem the surface of the ceramic base having soldering pads can be ground to make the pads flat and even with each other. However, this grinding may eliminate some of small soldering pads.

### Summary of the invention

An object of the present invention is to provide an LCC type semiconductor device having densely arranged and precisely formed small soldering pads.

This and other objects, features, and advantages are accomplished by a semiconductor device comprising a semiconductor chip, a ceramic base for mounting the semiconductor chip, and a plurality of soldering pads on an outer surface of the ceramic base for connection to an external member, the soldering pads being electrically connected to the semiconductor chip. The ceramic base has a plurality of holes from the outer surface toward the inner portion of the ceramic base. Conductor material is filled in the holes. The exposed surfaces of the filled conductor material form the soldering pads. The soldering pads thus take the same shape as the holes.

As stated above, a semiconductor device according to the present invention, the shape of the soldering pads is defined by the shape of the holes in the ceramic base. Such holes may be formed by means of a press or a laser beam. This allows precise formation of holes in the ceramic base and, therefore, allows soldering pads of a very small size, for example, less than 0.5 mm, even less than 0.25 mm, with a very short pitch, for example, less than 1.0 mm, even less than 0.5 mm.

Further, in a semiconductor device according to the present invention, no soldering pads are eliminated by grinding the surface of the ceramic base since there is always conductor material at the holes.

### Brief description of the drawings

The present invention will be described below with reference to the drawings, in which:

Fig. 1 is a partially broken side view of a prior art LCC type semiconductor device;

Fig. 2 is a bottom side view of the semiconductor device in Fig. 1, wherein a cap is removed;

Fig. 3 is a partially broken side view of an LCC type semiconductor device according to the present invention;

Fig. 4 is a bottom side view of the semiconductor device in Fig. 3, wherein a cap is removed;

Fig. 5 is a partially broken side view of an LCC type semiconductor device of another embodiment of the present invention; and

Fig. 6 shows a schematic pattern of probe pads on a surface of a semiconductor device in Fig. 5.

Description of the preferred embodiments

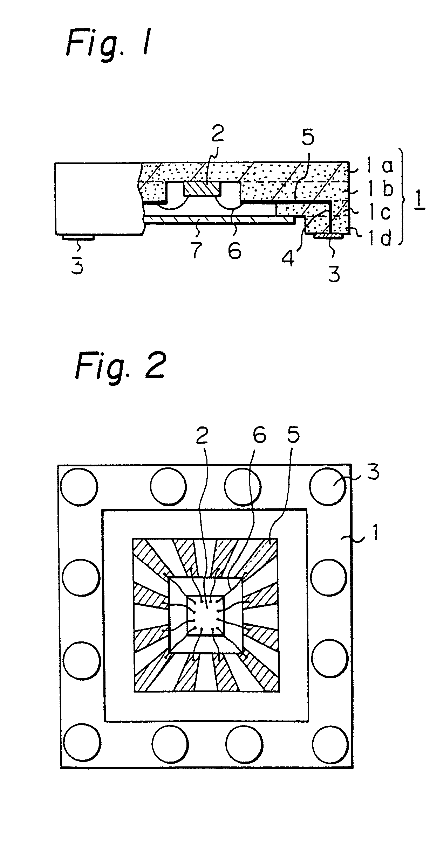

Before describing preferred embodiments of the present invention, a description of the prior art will be made for reference. In Figs. 1 and 2, reference numeral 1 denotes a ceramic base, 2 a semiconductor chip, 3 soldering pads, 4 and 5 metallization lines, 6 fine wires, and 7 a cap.

In fabricating this device, first to fourth green ceramic sheets 1a, 1b, 1c, and 1d of, e.g., alumina are prepared. Three green sheets 1b, 1c, and 1d have an aperture in the central portion thereof for receiving a semiconductor chip 2 and a cap 7. The fourth green sheet 1d has a plurality of through holes, corresponding to reference numeral 4 in the figures, having a diameter of about 0.1 mm to 0.3 mm along the periphery thereof filled with tungsten paste and a plurality of circular patterns, corresponding to reference numeral 3 in the figures, of tungsten paste on the bottom surface thereof, the circular patterns corresponding to and having contact with the tungsten paste in the through holes, respectively. The circular patterns of tungsten paste are made by the screen printing method.

The third green sheet 1c has a plurality of through holes corresponding to the above-mentioned through holes in the fourth green sheet 1d, in which tungsten paste is also filled. The second green sheet 1b has a plurality of radial patterns, corresponding to reference numeral 5 in the figures, of tungsten paste on the main surface thereof, the patterns 5 corresponding to the through holes mentioned above. These four green sheets 1a, 1b, 1c, and 1d are laminated to form a ceramic base 1 and are fired at a temperature of 1500°C to 1600°C to sinter the ceramic and metallize the tungsten paste. Thus, a plurality of metallization lines separated from each other are made from the soldering pads 3 to a central portion of the ceramic base 1 near the place for receiving the semiconductor chip 2. Wiring is made between the semiconductor chip 2 and the metallization lines 5. A cap 7 is soldered to seal the semiconductor chip 2 in.the ceramic base 1.

In an example of a prior art LCC type semiconductor device described above, the ceramic base 1 is 15 mm×15 mm in size and is provided with 120 circular soldering pads 3 (12 shown in Fig. 2) having a 0.5 mm diameter and a 1.0 mm pitch in a line along the periphery of the bottom surface of the ceramic base 1.

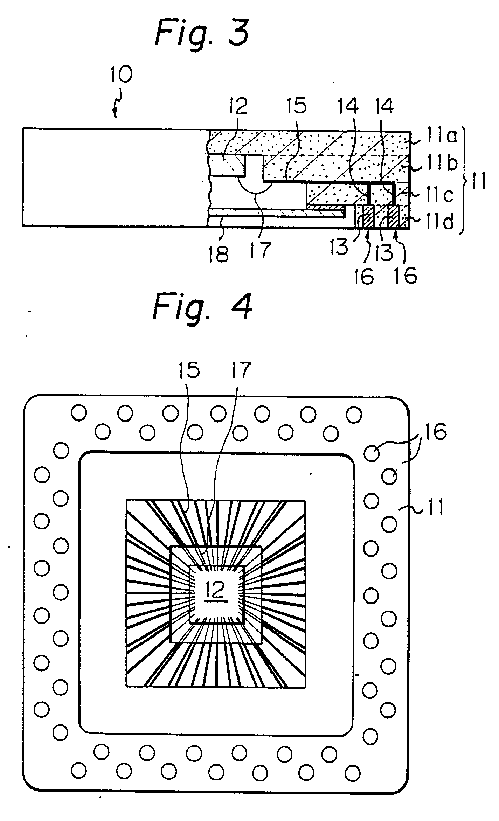

Figures 3 and 4 illustrate an example of an LCC type semiconductor device according to the present invention, in which 11 denotes a ceramic base, 12 a semiconductor chip, 13 a plurality of metallizations in through holes and soldering pads, 14 and 15 metallization lines, 17 fine wires, and 18 a cap.

The fabrication process of this device is similar to that of the prior art device as described above except for the step of making the soldering pads. Four first to fourth green ceramic sheets 11a, 11b, 11c, and 11d of alumina are laminated to form a ceramic base 11. The second to fourth green sheets 11b, 11c, and 11d have an aperture in the central portion thereof for receiving a semiconductor chip 12 and a cap 18. In the fourth green sheet 11d, a plurality of through holes, corresponding to reference numeral 13 in figures, having a 0.25 mm diameter are formed by means of a press machine and filled with tungsten paste. In the third green sheet 11c, the plurality of through holes, corresponding to reference numeral 14 in figures, of a 0.15 mm diameter are formed by means of a press machine and filled with tungsten paste, each of the through holes in the third green sheet 11c corresponding to each of the through holes in the fourth green sheet 11d. On a main surface of the second green sheet 11b, a plurality of radial patterns of tungsten paste are formed by screen printing, the radial patterns being separated from each other and corresponding to the through holes in the third green sheet 11c, respectively. A pattern of tungsten paste for receiving a semiconductor chip 12 is formed on the central portion of a main surface of the second green sheet 11b (not shown in the figures).

The four green ceramic sheets 11a, 11b, 11c, and 11d are laminated, pressed, and fired at a temperature of 1500°C to 1600°C to sinter the ceramic and metallize the tungsten paste. Thus, a plurality of metallizations 13, 14, and 15 are made separated from each other. It should be noted that each of the metallization lines 14 made by a through hole corresponds to one metallization line 15, though, in Fig. 3, the two metallization lines 14 look like they are connected to each other by the metallization line 15. The bottom surface of the ceramic base 11, including metallizations 13 of tungsten in the through holes, is ground flat. This grinding does not eliminate any patterns of the metallizations 13. Then, all externally exposed surfaces of the metallizations in the ceramic base 11 are plated with nickel and then with gold. The exposed surfaces 16 of the plated metallizations in the through holes 13 function as soldering pads.

Fine wires 17 are bonded to a semiconductor chip 12 and the metallization lines 15. A cap 18 is soldered onto the ceramic base 11 to seal the semiconductor chip 12 in the ceramic base 11. If it is desired to enhance the effect of cooling the semiconductor chip, a cooling fin of aluminum (not shown in figures) is adhered onto the top of the ceramic base 11.

In this example of an LCC type semiconductor device according to the present invention, the ceramic base 11 is 15 mm×15 mm in size and is provided with 320 soldering pads 16 (48 shown in Fig. 4) having a 0.25 mm diameter and a 0.5 mm pitch in two lines along the periphery of the bottom surface of the ceramic base 11. The number of soldering pads in this device is four times that of the prior art device mentioned before.

In this example, soldering pads are formed on a side of a ceramic base where a cavity for receiving a semiconductor chip is formed. They may, however, be formed on the opposite side thereof. The shape, size, and/or pitch of soldering pads in a device may also be different from the above-described example. The soldering pads may also be squares, rectangles, etc. The diameter or size of the soldering pads, i.e., that of the through holes near the external surface of the ceramic base may be larger or smaller than 0.5 mm. Further, the diameter or size of through holes formed internally in the ceramic base may be not only smaller than but also the same as or even larger than that of the through holes formed near the surface of the ceramic base, i.e., that of the soldering pads.

An LCC type semiconductor device may be provided with probe pads for testing the device. It is preferable that the probe pad be provided on the side of a semiconductor device opposite to the side where soldering pads are provided. This is because when the semiconductor device is mounted on a printed circuit board, the side of soldering pads is covered by the board. This makes difficult to use the soldering pads as probe pads. Further, forming broader probe pads is preferable for ensuring contact with probes. The LCC type semiconductor device as illustrated in Figs. 3 and 4 has a considerable surface for probe pads on the side opposite to the side of soldering pads. For this reason too, it is also preferable to provide probe pads on the side opposite to the side of soldering pads.

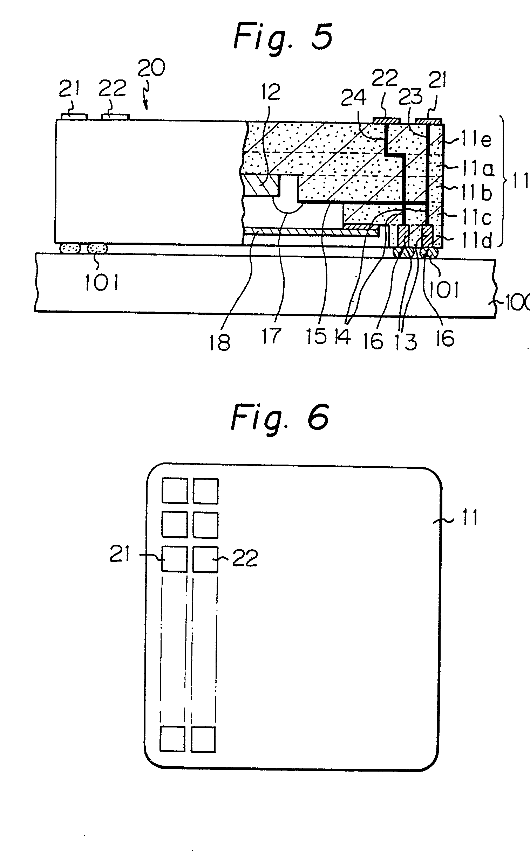

Figure 5 illustrates a schematical arrangement of metallization lines in an LCC type semiconductor device for providing probe pads. In Fig. 5, a semiconductor device 20 is similar to that in Fig. 3, 11 denoting a ceramic base, 12 a semiconductor chip, 13 metallizations for soldering pads, 14 and 15 metallization lines, 17 fine wires, and 18 a cap. The semiconductor device 20 has two lined probe pads 21 and 22 on the top surface of the ceramic base 11, this surface being opposite to the surface provided with the soldering pads 16. Figure 6 schematically illustrates the arrangement of the probe pads 21 and 22. Each of the probe pads 21 and 22 is electrically connected with each of the metallization lines 13 to 15 connected with each of the soldering pads 16 and the semiconductor chip 12, all of the metallization lines 13 to 15 being separated from each other. It is preferable that these electrical connections between the probe pads 21 and 22 and the metallization lines 13 to 15 connected with the soldering pads 16 and the semiconductor chip 12 are made by two types of metallization lines, one of which 23 is vertically straight and the other of which 24 is vertically turned so that enlarged areas can be used for probe pads 21 and 22. In fabrication of this type of a semiconductor device 20, a fifth ceramic green sheet 11e is used for turning the metallization lines 24. Probe pads 21 and 22 and vertical metallization lines 23 and 24 from the probe pads 21 and 22 to metallization lines 13 to 15 connected with probe pads 16 and a semiconductor chip 12 are made by firing tungsten paste printed on ceramic green sheets or filled in through holes formed in ceramic green sheets.

The produced semiconductor device 20 will be bonded onto a printed circuit board 100 by soldering 101 as in Fig. 5.

## Claims

1. A semiconductor device comprising: a semiconductor chip (12); a ceramic base (11) for mounting the semiconductor chip; and a plurality of soldering pads (16) on an outer surface of the ceramic base (11) for connection to an external member, the soldering pads (16) being electrically connected to the semiconductor chip (12); characterized in that the ceramic base (11) has a plurality of holes (13) from the outer surface toward an inner portion of the ceramic base (11) and conductor material is filled in the holes (13) to form the soldering pads by exposed surface (16) of the filled conductor material, the soldering pads having shapes and sizes defined by those of the holes.

2. A semiconductor device according to claim 1, characterized in that the plurality of soldering pads are arranged at a pitch less than 1.0 mm.

3. A semiconductor device according to claim 2, characterized in that the pitch of the soldering pads (16) is about 0.5 mm.

4. A semiconductor device according to claim 3, characterized in that the soldering pads (16) are circular having 0.25 mm diameter.

5. A semiconductor device according to claim 1, characterized in that the ceramic base (11) is of the alumina system.

6. A semiconductor device according to claim 1, characterized in that the soldering pads (16) are made of tungsten and plated with nickel.

7. A semiconductor device according to claim 1, characterized in that the soldering pads (16) are made of tungsten and plated with nickel and then with gold.

8. A semiconductor device according to claim 1, characterized in that said ceramic base (11) has a plurality of probe pads (21, 22) formed on a side opposite to the side where the soldering pads (16) are formed, the probe pads (21, 22) being electrically connected with the semiconductor chip (12) through metallization lines (23, 24) in the ceramic base (11).

## Patentansprüche

1. Halbleitervorrichtung mit: einem Halbleiterchip (12); einer keramischen Basis (11) zur Montage des Halbleiterchip; und einer Vielzahl von Lötanschlußstellen (16) auf einer äußeren Oberfläche der keramischen Basis (11) zur Verbindung mit einem externen Teil, welche Lötanschlußstellen (16) elektrisch mit dem Halbleiterchip (12) verbunden sind; dadurch gekennzeichnet, daß die keramische Basis (11), eine Vielzahl on Löchern (13) von der äußeren Oberfläche zu einem inneren Abschnitt der keramischen Basis (11) aufweist und Leitermaterial in die Löcher (13) gefüllt ist, um durch exponierte Oberflächen (16) des eingefüllten Leitermaterials die Lötanschlußstellen zu bilden, und die Lötanschlußstellen Formen und Größen haben, die durch diejenigen der Löcher definiert sind.

2. Halbleitervorrichtung nach Anspruch 1, dadurch gekennzeichnet, daß die Vielzahl von Lötanschlußstellen in einem Raster von weniger als 1,0 mm angeordnet sind.

3. Halbleitervorrichtung nach Anspruch 1, dadurch gekennzeichnet, daß der Raster der Lötanschlußstellen (16) etwa 0,5 mm beträgt.

4. Halbleitervorrichtung nach Anspruch 3, dadurch gekennzeichnet, daß die Lötanschlußstellen (16) kreisförmig ausgebildet sind und einen Durchmesser von 0,25 mm haben.

5. Halbleitervorrichtung nach Anspruch 1, dadurch gekennzeichnet, daß die keramische Basis (11) aus dem Aluminiumsystem besteht.

6. Halbleitervorrichtung nach Anspruch 1, dadurch gekennzeichnet, daß die Lötanschlußstellen (16) aus Wolfram bestehen und mit Nickel plattiert sind.

7. Halbleitervorrichtung nach Anspruch 1, dadurch gekennzeichnet, daß die Lötanschlußstellen (16) aus Wolfram bestehen und mit Nickel und danach mit Gold plattiert sind.

8. Halbleitervorrichtung nach Anspruch 1, dadurch gekennzeichnet, daß die keramische Basis (11) eine Vielzahl von Prüfanschlußstellen (21, 22) hat, die auf einer Seite gebildet sind, welches der Seite gegenüberliegt, auf welcher die Lötanschlußstellen (16) gebildet sind, und die Prüfanschlußstellen (21, 22) über Metallisierungsleitungen (23, 24) in der keramischen Basis (11) mit dem Halbleiterchip (12) elektrisch verbunden sind.

## Revendications

1. Dispositif à semiconducteurs comprenant: une puce semiconductrice (12); une base céramique (11) servant au montage de la puce semiconductrice; et plusieurs plots de soudage (16) disposés sur une surface externe de la base céramique (11) afin de permettre la connexion à un élément externe, les plots de soudage (16) étant électriquement connectés à la puse semiconductrice (12); caractérisé en ce que la base céramique (11) possède plusieurs trous (13) partant de la surface extérieure en direction d'une partie intérieure de la base céramique (11) et en ce qu'un matériau conducteur remplit les trous (13) de manière à former les plots de soudage au moyen des surfaces exposées (16) du matériau conducteur de remplissage, les plots de soudage ayant les formes et les dimensions définies par celles des trous.

2. Dispositif à semiconducteurs selon la revendication 1, caractérisé en ce que les différents plots de soudage sont disposés suivant un pas inférieure à 1,0 mm.

3. Dispositif à semiconducteurs selon la revendication 2, caractérisé en ce que le pas des plots de soudage (16) est d'environ 0,5 mm.

4. Dispositif à semiconducteurs selon la revendication 3, caractérisé en ce que les plots de soudage (16) sont circulaires et possèdent un diamère de 0,25 mm.

5. Dispositif à semiconducteurs selon la revendication 1, caractérisé en ce que la base céramique (11) est du système de l'alumine.

6. Dispositif à semiconducteurs selon la revendication 1, caractérisé en ce que les plots de soudage (16) sont faits de tungstène et sont plaqués à l'aide de nickel.

7. Dispositif à semiconducteurs selon la revendication 1, caractérisé en ce que les plots de soudage (16) sont faits de tungstène et sont plaqués à l'aide de nickel, puis d'or.

8. Dispositif à semiconducteurs selon la revendication 1, caractérisé en ce que ladite base céramique (11) possède plusieurs plots témoins (21, 22) formés sur le côté opposé à celui où les plots de soudage (16) sont formés, les plots témoins (21, 22) étant électriquement connectés avec la puce semiconductrice (12) par l'intermédiaire de lignes de métallisation (23, 24) disposées dans la base céramique (11).

*Fig. 1*

*Fig. 2*

# Fig. 3

# Fig. 4

## Fig. 5

## Fig. 6